## Europäisches Patentamt

## European Patent Office

## Office européen des brevets

(19)

(11) Numéro de publication : **0 172 772**
**B1**

(12)

# FASCICULE DE BREVET EUROPÉEN

(45) Date de publication du fascicule du brevet :
**07.06.89**

(21) Numéro de dépôt : **85401566.6**

(22) Date de dépôt : **31.07.85**

(51) Int. Cl.⁴ : **H 01 L 21/76, H 01 L 21/74**

(54) Circuit intégré CMOS et procédé de fabrication de zones d'isolation électrique dans ce circuit intégré.

(30) Priorité : **07.08.84 FR 8412463**

(43) Date de publication de la demande :
**26.02.86 Bulletin 86/09**

(45) Mention de la délivrance du brevet :
**07.06.89 Bulletin 89/23**

(84) Etats contractants désignés :
**DE GB IT NL**

(73) Titulaire : **COMMISSARIAT A L'ENERGIE ATOMIQUE
31/33, rue de la Fédération
F-75015 Paris (FR)**

(72) Inventeur : **Jeuch, Pierre
13, rue du Parc
F-38170 Seyssins (FR)**

(74) Mandataire : **Mongrédien, André et al
c/o BREVATOME 25, rue de Ponthieu
F-75008 Paris (FR)**

(56) Documents cités :
EP—A— 0 073 370
US—A— 4 044 452
IBM TECHNICAL DISCLOSURE BULLETIN, vol. 25, no. 7A, décembre 1982, pages 3350-3352, New York, US; H.H. CHAO et al.: "Heavy doping Isolation for CMOS integrated circuits"
ELECTRONIC DESIGN, vol. 31, no. 22, octobre 1983, pages 44-51, Waseca, MN, Denville, N.J., US; "CMOS advances clearing speed and density hurdles"
IBM TECHNICAL DISCLOSURE BULLETIN, vol. 25, no. 9, février 1983, pages 4768-4772, New York, US; C.G. JAMBOTKAR: "Method to realize submicrometer-wide images"
IBM TECHNICAL DISCLOSURE BULLETIN, vol. 26, no. 3A, août 1983, pages 940-941, New York, US; G.A. SAI-HALASZ et al.: "Bipolar dynamic RAM cell structure with low soft-error rate"
IEDM 1983, p.23-26, K.M.CHAM et al.:"Caracterisation and Modelling of the trench for the tranch isolated CMOS Technology"

Jouve, 18, rue St-Denis, 75001 Paris, France

**Description**

La présente invention a pour objet un circuit intégré CMOS et un procédé de fabrication de zones d'isolation électrique dans un tel circuit intégré.

Elle s'applique en particulier dans le domaine de l'électronique et de l'informatique pour réaliser notamment des portes logiques, des bascules, des mémoires mortes ou vives, etc...

La recherche d'une forte densité d'intégration dans les circuits intégrés CMOS nécessite d'utiliser une technique d'isolement spéciale entre les différents composants de ces circuits et notamment entre les transistors à canal N et les transistors à canal P de ces circuits CMOS, lorsque l'on veut réduire la distance entre les transistors complémentaires.

L'une des techniques récentes d'isolation utilisée dans ce but est basée sur la réalisation de tranchées dans le substrat semiconducteur, tranchées que l'on oxyde ensuite puisque l'on remplit par un matériau tel que du silicium polycristallin ou de l'oxyde de silicium. Ce remplissage des tranchées se fait par le dépôt du matériau de remplissage, sur toute la surface du circuit intégré, suivi d'un enlèvement de l'excédent dudit matériau déposé hors des tranchées. Cet excédent peut être enlevé par gravure chimique ou plasma. En général, on réalise ensuite au-dessus de la tranchée un oxyde de champ localisé.

Cette technique d'isolement par tranchées surmontées d'un oxyde de champ localisé a notamment été décrite dans un article IEDM de 1982, pages 237 à 240, intitulé « Deep trench isolated CMOS devices ».

Cette technique d'isolation permet d'atteindre de grandes profondeurs d'isolation (plusieurs μm) entre les différents composants des circuits intégrés tout en assurant une bonne isolation en surface. Malheureusement, dans une telle technique d'isolation, se pose le problème d'une inversion de conductivité sur les flancs des tranchées d'isolement et donc de la formation d'un canal parasite ; ce problème d'inversion parasite de conductivité, notamment décrit dans un article IEDM de 1983, pages 23 à 26, intitulé « Characterization and modeling of the trench surface inversion problem for the trench isolated CMOS technology » de Kit M. Cham et al. nécessite d'éloigner les transistors des tranchées d'isolement et plus spécialement les transistors à canal N des circuits CMOS, limitant ainsi la densité d'intégration de ces circuits intégrés.

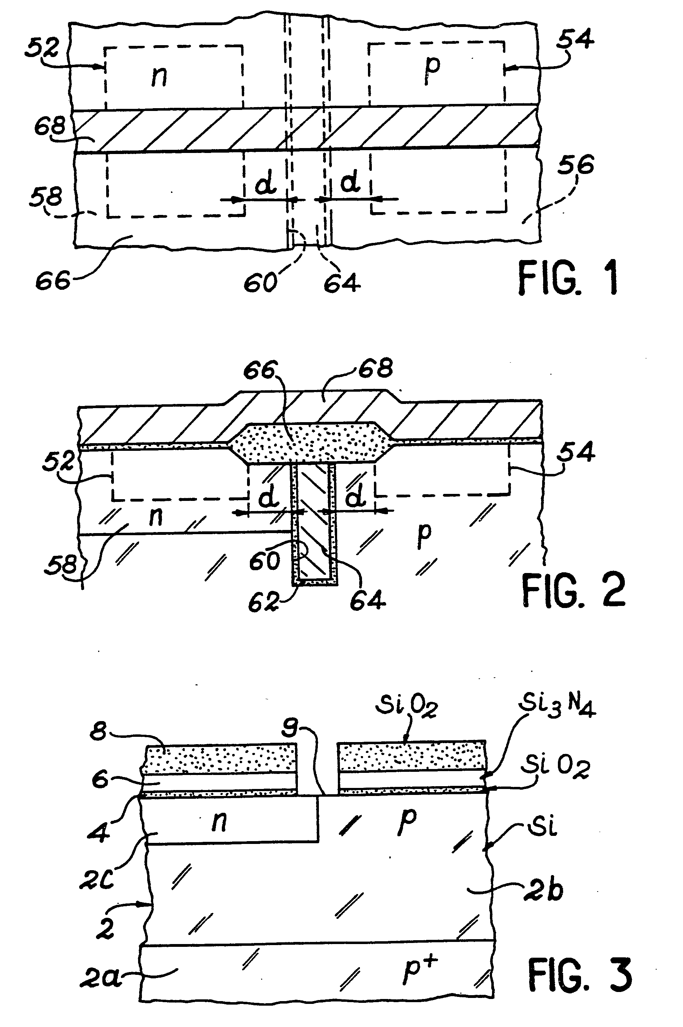

Ceci est illustré sur les figures 1 et 2 représentant schématiquement, en vue de dessus et en coupe longitudinale, une partie d'un circuit intégré CMOS de l'art antérieur au niveau d'une tranchée d'isolement.

Sur ces figures, les références 52 et 54 représentent respectivement les régions occupées par un transistor à canal P et un transistor à canal N. Ces deux transistors sont par exemple réalisés dans un même substrat en silicium 56 de type p, la référence 58 correspondant au caisson de type n dans lequel est réalisé le transistor à canal P. Ces deux transistors sont isolés électriquement l'un de l'autre par une tranchée d'isolement 60 pratiquée dans le substrat ; les flancs et le fond de cette tranchée 60 sont recouverts d'un film d'oxyde 62 et l'intérieur de la tranchée est rempli d'un matériau notamment isolant 64. Cette tranchée d'isolement 60 est surmontée d'un oxyde de champ 66. La référence 68 correspond à la couche conductrice, généralement en silicium polycristallin dopé, dans laquelle sont réalisées les grilles des deux transistors.

Comme représenté sur les figures 1 et 2, les transistors 52 et 54 sont nécessairement situés, à une certaine distance d de la tranchée d'isolement 60 pour éviter la formation d'un canal parasite dû à l'inversion de conductivité sur les flancs de la tranchée ; les régions séparant la tranchée des transistors, étant une région d'oxyde de champ 66 (figure 1).

La présente invention a justement pour but un circuit intégré CMOS et un procédé de fabrication de zones d'isolation électrique dans un tel circuit intégré permettant de remédier aux différents inconvénients, donnés précédemment. En particulier, le circuit intégré CMOS de l'invention, utilisant la technique d'isolation par tranchée d'isolement, présente une densité d'intégration nettement plus élevée que celle des circuits CMOS de l'art antérieur. Par ailleurs, ce circuit ne présente pas d'inversion de conductivité sur les flancs des tranchées et donc de canal parasite.

De façon plus précise, l'invention a pour objet un circuit intégré CMOS comportant des transistors MOS à canal N et des transistors MOS à canal P, réalisés sur un même substrat en silicium d'un type donné de conductivité, des tranchées d'isolement pratiquées dans le substrat pour isoler électriquement les transistors à canal N des transistors à canal P, les flancs des tranchées étant recouverts d'un film isolant, caractérisé en ce que chaque tranchée comporte au moins une partie en contact direct avec un transistor à canal N et un transistor à canal P et est remplie d'un matériau conducteur constituant une électrode conductrice reliée au substrat correspondant à la masse, via un dopage dans le fond de la tranchée d'isolement ayant le même type de conductivité que celui du substrat.

La présence des électrodes conductrices dans les tranchées d'isolement permet de supprimer toute inversion de conductivité sur les flancs desdites tranchées d'isolement et en particulier du côté des transistors à canal N des circuits CMOS ; ceci permet de rapprocher au maximum les transistors des tranchées d'isolement.

L'invention a aussi pour objet un procédé de fabrication de zones d'isolation électrique servant à isoler électriquement entre eux les différents transistors MOS d'un circuit intégré CMOS, et en particulier les transistors à canal N et les transistors à canal P de ces circuits.

Selon l'invention, ce procédé se caractérise en ce qu'il comprend les étapes suivantes :

a) réalisation de plusieurs tranchées dans un substrat en silicium d'un type donné de conductivité,

b) oxydation thermique du substrat entraînant la formation d'un film d'oxyde sur les flancs et le fond des tranchées,

c) élimination de la partie du film d'oxyde située dans le fond des tranchées,

d) dopage dans le fond des tranchées ayant le même type de conductivité que le substrat, et,

e) remplissage des tranchées par un matériau conducteur constituant ainsi une électrode reliée au substrat correspondant à la masse du circuit,

f) réalisation d'un oxyde de champ localisé au-dessus de chaque tranchée.

Ce procédé de fabrication permet ainsi de réaliser une électrode conductrice en silicium polycristallin connectée au substrat en silicium, c'est-à-dire à la masse, à l'intérieur de chaque tranchée d'isolement.

De façon avantageuse, on réalise l'étape c) par un procédé de gravure anisotrope du film d'oxyde, tel qu'un procédé de gravure ionique réactive.

L'étape d) du procédé consiste à réaliser un dopage dans le fond des tranchées, c'est-à-dire un dopage du substrat juste au-dessous des tranchées ; ce dopage est par exemple réalisé par implantation ionique.

Ce dopage permet d'assurer une meilleure liaison électrique entre les électrodes conductrices, réalisées dans les tranchées, et le substrat semiconducteur, tout en évitant de faire des tranchées trop profondes.

Selon un autre mode préféré de mise en oeuvre du procédé de l'invention, le substrat est constitué d'une zone faiblement dopée surmontant une zone fortement dopée, la zone faiblement dopée étant obtenue par épitaxie à partir de la zone fortement dopée.

Un tel substrat présente l'avantage de comporter un dopage plus élevé en profondeur qu'en surface. Ceci permet d'éviter un éventuel verrouillage (en anglais latch up) du circuit CMOS.

Selon un autre mode préféré de mise en oeuvre du procédé de l'invention, le matériau de remplissage est du silicium polycristallin ou un siliciure d'un métal réfractaire. De préférence, le silicium polycristallin est dopé de type $n^+$ ou $p^+$ et le siliciure est le siliciure de tungstène ($WSi_2$).

L'oxyde de champ localisé au-dessus de chaque tranchée assure une bonne isolation en surface entre les différents composants desdits circuits intégrés.

D'autres caractéristiques et avantages de l'invention ressortiront mieux de la description qui va suivre, donnée à titre illustratif et non limitatif, en référence aux figures annexées, dans lesquelles :

— les figures 1 et 2, déjà décrites, représentent schématiquement, en vue de dessus et en coupe longitudinale, une partie d'un circuit CMOS de l'art antérieur au niveau d'une tranchée d'isolement,

— les figures numérotées de 3 à 8 illustrent schématiquement, en coupe longitudinale, les différentes étapes du procédé de fabrication de zones isolantes dans un circuit CMOS, conformément à l'invention, et

— les figures 9 et 10 représentent schématiquement, en vue de dessus et en coupe longitudinale, une partie d'un circuit intégré CMOS conformément à l'invention.

La description qui va suivre est relative à La fabrication d'une zone d'isolation entre un transistor MOS à canal N et un transistor MOS à canal P d'un circuit CMOS à caisson n, c'est-à-dire réalisé sur un substrat de type p, et à la partie du circuit intégré CMOS correspondant. Bien entendu, le procédé selon l'invention est d'application beaucoup plus générale ; il peut être utilisé à chaque fois que l'on désire isoler entre eux des composants quelconques d'un circuit intégré CMOS tels que deux transistors à canal N ou deux transistors à canal P.

Dans le cas représenté sur les figures 3 à 9, le substrat en silicium monocristallin, portant la référence générale 2, comprend une zone 2a de type $p^+$, comportant notamment au moins $10^{16}$ atomes/cm³ d'ions de bore, à partir de laquelle une zone 2b de type p a été, de façon connue, épitaxiée ; dans cette zone 2b sera réalisé ultérieurement le transistor à canal N. Par ailleurs, dans la zone épitaxiée 2b est fabriqué un caisson 2c de type n dans lequel sera réalisé ultérieurement le transistor à canal P. Ce caisson 2c de type n est réalisé classiquement par une diffusion ou une implantation d'ions notamment de phosphore à des doses de $5.10^{12}$ atomes/cm².

La concentration d'impuretés de type p (bore) dans le substrat 2, plus élevée en profondeur (zone 2a) qu'en surface, (zone 2b), permet d'éviter selon un procédé bien connu le verrouillage (latch up) de La structure $n^+pnp^+$ réalisée par les sources $n^+$ et $p^+$ des transistors à canal N et à canal P, le substrat p et le caisson n.

Après réalisation du substrat 2, on recouvre celui-ci, comme représenté sur la figure 3, d'une couche de matériau isolant 4 de préférence en oxyde de silicium ($SiO_2$). Cette couche 4 peut notamment être obtenue par une oxydation thermique du substrat en silicium 2 à une température de l'ordre de 900 °C. Cette couche 4, présentera une épaisseur variant de 10 à 50 nm (100 à 500 Å).

Sur cette couche mince d'oxyde de silicium 4, on réalise ensuite une autre couche d'isolant 6, de préférence en nitrure de silicium ($Si_3N_4$). Cette couche de nitrure de silicium 6 présente par exemple une épaisseur d'environ 80 nm (800 Å) et peut être obtenue par un dépôt, notamment du type dépôt chimique en phase vapeur (CVD ou LPCVD). Cette couche de nitrure 6, après gravure, servira ultérieurement à la localisation de l'oxyde de champ.

Sur la couche 6, on réalise ensuite une autre couche d'isolant 8, de préférence en oxyde de silicium. Cette couche d'oxyde 8 présente une épaisseur d'environ 1 μm. Elle peut être obtenue par dépôt, notamment par un dépôt chimique en phase vapeur (CVD ou LPCVD). Cette couche d'oxyde 8, après gravure, servira ultérieurement de masque pour graver la tranchée dans le substrat.

On réalise ensuite, comme représenté sur la figure 3, une gravure de préférence anisotrope des couches isolantes 4, 6 et 8, c'est-à-dire une gravure réalisée suivant une seule direction de l'espace, de façon à mettre à nu une région 9 du substrat 2, région dans laquelle sera réalisée, ultérieurement, la tranchée d'isolement. La gravure de ces trois couches empilées peut être réalisée après avoir déposé sur la couche isolante 8 un masque de résine (non représenté), réalisé par des procédés classiques de la photolithographie et servant à définir l'emplacement de la tranchée d'isolement à réaliser.

La gravure anisotrope des couches d'isolant 4, 6 et 8 peut être effectuée par une technique de gravure sèche du type ionique réactive en utilisant comme agent de gravure le trifluorométhane (CHF$_3$) dans le cas particulier où les couches 4, 6 et 8 sont réalisées respectivement en oxyde de silicium, en nitrure de silicium et en oxyde de silicium.

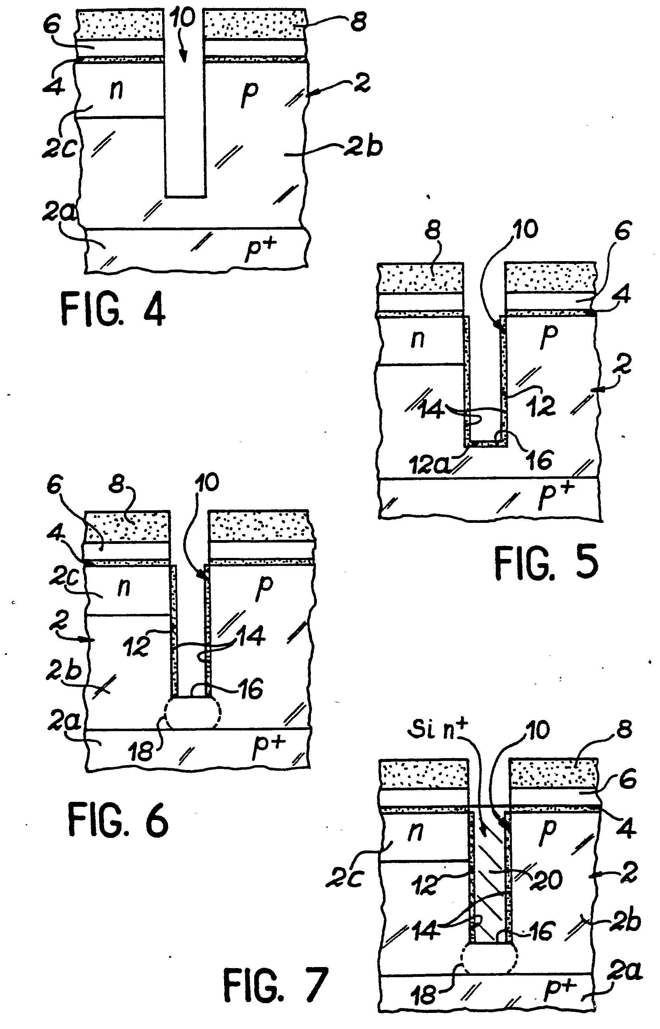

L'étape suivante du procédé, comme représentée sur la figure 4, consiste à réaliser une gravure de préférence anisotrope de la région 9 du substrat mise à nu de façon à réaliser une tranchée 10. De préférence, cette tranchée 10 doit être plus profonde que le caisson 2c de type n, d'environ 1 μm, afin d'éviter le perçage entre ledit caisson et l'électrode qui sera fabriquée ultérieurement dans la tranchée. Par exemple, cette dernière présente une profondeur de l'ordre de 5 μm, le caisson 2c ayant une épaisseur de l'ordre de 4 μm. De plus, elle présente une largeur de l'ordre de 1 μm.

Cette tranchée 10 peut être réalisée par un procédé de gravure ionique réactive, avec comme agent de gravure du tétrachlorure de carbone (CCL$_4$) ou de l'hexafluorure de soufre (SF$_6$). Cette gravure est réalisée en utilisant la couche d'oxyde de silicium 8 gravée comme masque.

L'étape suivante du procédé, comme représenté sur la figure 5, consiste à oxyder thermiquement le substrat 2 gravé, par exemple à une température voisine de 1000 °C. Cette oxydation permet d'obtenir un film d'oxyde 12, ayant une épaisseur d'environ 100 nm (1000 Å), recouvrant les flancs 14 de la tranchée ainsi que le fond 16 de celle-ci.

Les étapes suivantes du procédé, décrites en référence aux figures 6 et 7, concernent la réalisation d'une électrode conductrice, à l'intérieur de la tranchée 10, connectée au substrat 2, c'est-à-dire à la masse.

La réalisation de cette électrode conductrice permet notamment d'éviter toute inversion de conductivité sur les flancs 14 de la tranchée et en particulier dans la région 2b du substrat de type p, dans laquelle sera réalisé ultérieurement le transistor à canal N ; le flanc de la tranchée du côté de la région 2c du substrat de type n, dans laquelle sera réalisé ultérieurement le transistor à canal P, est beaucoup moins sensible à ces inversions parasites.

Selon l'invention, l'électrode conductrice est réalisée tout d'abord en éliminant la partie 12a (figure 5) du film d'oxyde de silicium 12, située dans le fond 16 de la tranchée 10. La structure obtenue est représentée sur la figure 6. Cette étape est réalisée de préférence par un procédé de gravure anisotrope et notamment par un procédé de gravure ionique réactive utilisant comme agent d'attaque du trifluorométhane (CHF$_3$). L'utilisation d'une gravure anisotrope permet d'éliminer la région 12a du film 12 sans pour cela éliminer les parties de ce film situées sur les flancs 14 de la tranchée 10. La couche 8 gravée d'oxyde de silicium est utilisée comme masque à cette gravure.

L'étape suivante du procédé consiste à réaliser un dopage dans le fond 16 de la tranchée 10, c'est-à-dire dans la région du substrat située au-dessous de la tranchée 10, cette région dopée portant la référence 18. Ce dopage est réalisé de préférence par une implantation ionique avec des ions de conductivité de type p, comme par exemple des ions de bore, avec une énergie de 100 keV et une dose de 2.10$^{16}$ atomes·cm$^{-2}$. Il permet d'assurer une meilleure liaison entre l'électrode, réalisée dans la tranchée 10, et le substrat 2, tout en évitant de faire une tranchée trop profonde.

La dernière étape de réalisation de l'électrode conductrice à l'intérieur de la tranchée 10 consiste, comme représenté sur la figure 7, à remplir la tranchée 10 par un matériau conducteur 20, constitué notamment par du silicium polycristallin de préférence de type n$^+$ ou p$^+$ ou par un siliciure tel que le siliciure de tungstène (WSi$_2$). Ce remplissage peut être réalisé par un dépôt isotrope et notamment par la technique de dépôt chimique en phase vapeur (CVD ou LPCVD), de façon à remplir complètement la tranchée 10.

Après remplissage de la tranchée 10, on élimine, si nécessaire, l'excédent de matériau conducteur 20 pouvant se trouver en dehors de la tranchée 10 de façon à ne laisser de ce matériau 20 que la partie située à l'intérieur de la tranchée, comme représenté sur la figure 7. Cette élimination peut par exemple être réalisée par une gravure sèche du type ionique réactive avec de l'hexafluorure de soufre comme agent d'attaque.

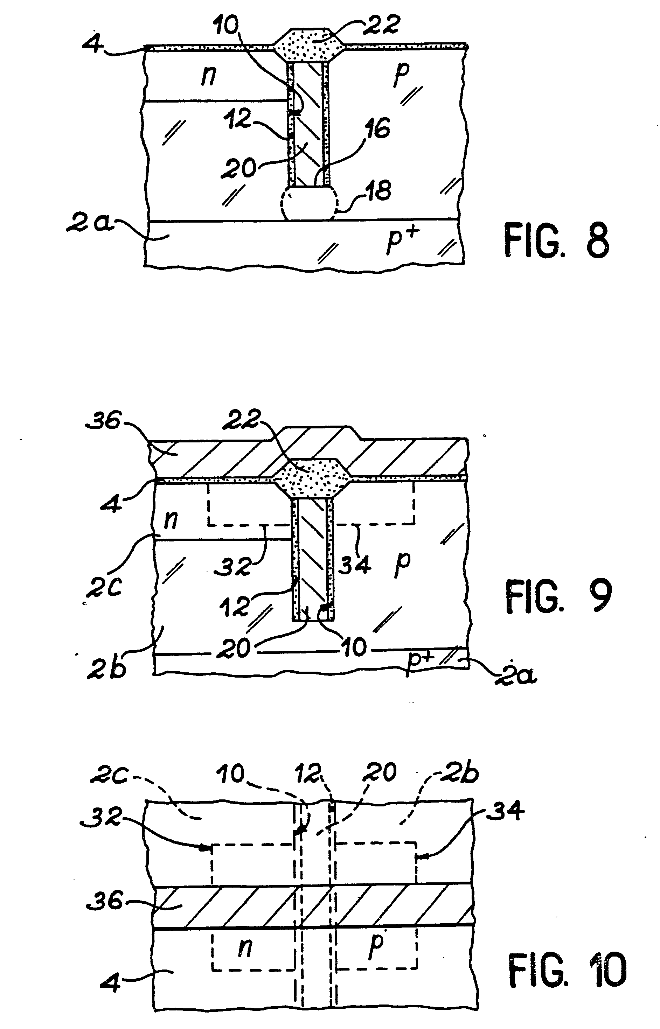

L'étape suivante du procédé consiste, comme représenté sur la figure 8, à éliminer la couche d'oxyde de silicium 8 ayant servi de masque à la réalisation de la tranchée 10 et à l'implantation dans le fond 16 de la tranchée. On utilisera par exemple une gravure humide avec comme agent d'attaque un mélange d'acide fluorhydrique et de fluorure d'ammonium.

Les étapes suivantes du procédé consistent à réaliser classiquement un oxyde de champ 22, par exemple par oxydation thermique du matériau 20 remplissant la tranchée 10 lorsque celui-ci est en silicium polycristallin, la couche 6 gravée de nitrure de silicium servant à la localisation de cet oxyde de champ sur la tranchée 10. L'épaisseur de cet oxyde de champ peut être voisine de 600 nm (6000 Å).

Ensuite, on peut éliminer la couche de nitrure de silicium 6, par exemple par une gravure chimique avec de l'acide orthophosphorique ($H_3PO_4$).

Le procédé de l'invention, grâce à la formation d'une électrode conductrice à l'intérieur des tranchées d'isolement, permet d'améliorer l'isolation électrique entre Les différents composants des circuits intégrés CMOS, et notamment l'isolation entre Les transistors de type N et les transistors de type P de ces circuits.

En effet, la présence de l'électrode conductrice reliée à la masse à l'intérieur de la tranchée 10 permet d'éviter les inversions de conductivité sur Les flancs de ladite tranchée et donc la formation d'un canal parasite. Ceci permet de fabriquer les transistors à canal N et P du circuit CMOS de façon que ceux-ci soient au contact de la tranchée d'isolement, contrairement à l'art antérieur. Ceci est illustré sur les figures 9 et 10.

Sur ces figures les références 32 et 34 représentent respectivement les régions occupées par le transistor à canal P et le transistor à canal N. La référence 36 correspond à la couche conductrice, généralement en silicium polycristallin dopé, dans laquelle sont réalisées les grilles des deux transistors. Conformément à l'invention, les transistors 32 et 34 sont situés au contact de la tranchée d'isolement 10, sans qu'aucune région d'oxyde de champ 22 ne soit prévue entre la tranchée 10 et les transistors 32 et 34 (figure 10).

## Revendications

1. Circuit intégré CMOS comportant des transistors MOS à canal N et des transistors MOS à canal P, réalisés sur un même substrat (2) en silicium d'un type donné de conductivité, des tranchées d'isolement (10) pratiquées dans le substrat pour isoler électriquement les transistors à canal N des transistors à canal P, les flancs (14) des tranchées (10) étant recouverts d'un film isolant (12), caractérisé en ce que chaque tranchée (10) comporte au moins une partie en contact direct avec un transistor à canal N et un transistor à canal P et est remplie d'un matériau conducteur constituant une électrode conductrice reliée au substrat (12) correspondant à la masse, via un dopage dans le fond de la tranchée d'isolement ayant le même type de conductivité que celui du substrat.

2. Circuit intégré selon la revendication 7, caractérisé en ce que le substrat (2) comprend une zone faiblement dopée (2b) épitaxiée sur une zone fortement dopée (2a), le dopage du fond (16) des tranchées étant au contact de la zone fortement dopée.

3. Circuit intégré selon la revendication 1 ou 2, caractérisé en ce que le matériau conducteur (20) est du silicium polycristallin dopé ou un siliciure d'un métal réfractaire.

4. Circuit intégré selon l'une quelconque des revendications 1-3, caractérisé en ce qu'un oxyde de champ (22) localisé est prévu au-dessus de chaque tranchée (10) d'isolement.

5. Procédé de fabrication de zones d'isolation électriques servant à isoler électriquement les transistors MOS à canal N des transistors MOS à canal P d'un circuit intégré CMOS, caractérisé en ce qu'il comprend les étapes suivantes :

a) réalisation de plusieurs tranchées (10) dans un substrat en silicium (2) d'un type donné de conductivité,

b) oxydation thermique du substrat entraînant la formation d'un film d'oxyde (12) sur les flancs (14) et le fond (16) des tranchées,

c) élimination de la partie (12a) du film d'oxyde (12) située dans le fond (16) des tranchées,

d) dopage dans le fond (16) des tranchées (10) ayant le même type de conductivité que le substrat, et,

e) remplissage des tranchées (10) par un matériau conducteur (20) constituant ainsi une électrode reliée au substrat (2) correspondant à la masse du circuit,

f) réalisation d'un oxyde de champ localisé (22) au-dessus de chaque tranchée (10).

6. Procédé de fabrication selon la revendication 5, caractérisé en ce que l'on réalise l'étape c) par une gravure anisotrope du film d'oxyde (12).

7. Procédé de fabrication selon la revendication 5 ou 6, caractérisé en ce que le substrat (2) comprend une zone faiblement dopée (2b) surmontant une zone fortement dopée (2a), la zone faiblement dopée (2b) étant obtenue par épitaxie à partir de la zone fortement dopée (2a), le dopage du fond des tranchées étant au contact de la zone fortement dopée.

8. Procédé de fabrication selon l'une quelconque des revendications 5 à 7, caractérisé en ce que l'étape a) est réalisée par un procédé de gravure anisotrope.

9. Procédé de fabrication selon l'une quelconque des revendications 5 à 8, caractérisé en ce que le matériau de remplissage (20) est du silicium polycristallin dopé ou un siliciure d'un métal réfractaire.

10. Procédé de fabrication selon la revendication 9, caractérisé en ce que le silicium polycristallin est dopé de type $n^+$ ou $p^+$.

11. Procédé de fabrication selon la revendication 9, caractérisé en ce que le siliciure est du siliciure de tungstène.

12. Procédé de fabrication selon l'une quelconque des revendications 5 à 11, caractérisé en ce que l'on effectue l'étape a) après avoir réalisé un masque (6, 11) sur le substrat (2) servant à définir les emplacements des zones d'isolation à réaliser et en ce que l'on élimine ce masque (6, 8) après formation de l'oxyde de champ localisé (22).

13. Procédé de fabrication selon la revendication 12, caractérisé en ce que le masque est réalisé en nitrure de silicium.

## Claims

1. CMOS integrated circuit having n-channel MOS transistors and p-channel MOS transistors produced on the same silicon substrate (2) with a given conductivity type, isolation trenches (100) made in the substrate for electrically isolating the n-channel transistors from the p-channel transistors, the sides (14) of the trenches (10) being covered with an insulating film (12), characterized in that each trench (10) has at least one part in direct contact with a n-channel transistor and a p-channel transistor and is filled with a conductive material constituting a conductive electrode connected to the substrate (12) corresponding to earth, via a doping in the bottom of the isolation trench having the same conductivity type as that of the substrate.

2. Integrated circuit according to claim 1, characterized in that the substrate (2) comprises a weakly doped zone (2b) epitaxied on to a highly doped zone (2a), the doping of the bottom (16) of the trenches being in contact with the highly doped zone.

3. Integrated circuit according to claims 1 or 2, characterized in that the conductive material (20) is doped polycrystalline silicon or a refractory metal silicide.

4. Integrated circuit according to any one of the claims 1 to 3, characterized in that a local field oxide (22) is provided above each isolation trench (10).

5. Process for the production of electrical isolation zones for electrically isolating the n-channel MOS transistors from the p-channel MOS transistors of a CMOS integrated circuit, characterized in that it comprises the following stages :

a) producing several trenches (10) in a silicon substrate (2) of a given conductivity type,

b) thermal oxidation of the substrate leading to the formation of an oxide film (12) on the sides (14) and bottom (16) of the trenches,

c) elimination of that part (12a) of the oxide film (12) which is located in the bottom (16) of the trenches,

d) doping in the bottom (16) of the trenches (10) with the same conductivity type as the substrate,

e) filling the trenches (10) with a conductive material (20), thus constituting an electrode connected to the substrate corresponding to the circuit earth and

f) producing a local field oxide (22) above each trench (10).

6. Production process according to claim 5, characterized in that stage c) is performed by anisotropically etching the oxide film (12).

7. Production process according to claims 5 or 6, characterized in that the substrate (2) comprises a weakly doped zone (2b) surmounting a strongly doped zone (2a), the weakly doped zone (2b) being obtained by epitaxy from the strongly doped zone (2a), the doping of the bottom of the trenches being in contact with the strongly doped zone.

8. Production process according to any one of the claims 5 to 7, characterized in that stage a) is performed by an anisotropic etching process.

9. Production process according to any one of the claims 5 to 8, characterized in that the filling material (20) is doped polycrystalline silicon or a refractory metal silicide.

10. Production process according to claim 9, characterized in that the polycrystalline silicon is n$^+$ or p$^+$ doped.

11. Production process according to claim 9, characterized in that the silicide is tungsten silicide.

12. Production process according to any one of the claims 6 to 11, characterized in that stage a) is performed after producing a mask (6, 8) on the substrate (2) for defining the locations of the isolation zones to be produced and in that said mask (6, 8) is eliminated following the formation of the local field oxide (22).

13. Production process according to claim 12, characterized in that the mask is made from silicon nitride.


**Patentansprüche**

1. Integrierte CMOS-Schaltung, enthaltend N-Kanal-MOS-Transistoren und P-Kanal-MOS-Transistoren auf einem gleichen Siliciumsubstrat (2) eines gegebenen Leitfähigkeitstyps, in dem Substrat ausgebildete Isolationsgräben (10), um die N-Kanal-Transistoren von den P-Kanal-Transistoren elektrisch zu isolieren, wobei die Flanken (14) der Gräben (10) von einem Isolierfilm (12) bedeckt sind, dadurch gekennzeichnet, daß jeder Graben (10) wenigstens einen Abschnitt aufweist, der direkt mit einem N-Kanal-Transistor und einem P-Kanal-Transistor in Kontakt ist und mit einem Leitermaterial gefüllt ist, das eine leitfähige Elektrode bildet, die mit dem der Masse entsprechenden Substrat (12) über eine Dotierung im Boden des Isolationskanals verbunden ist, die den gleichen Leitfähigkeitstyp hat, wie die des Substrats.

2. Integrierte Schaltung nach Anspruch 1, dadurch gekennzeichnet, daß das Substrat (2) eine schwach dotierte Zone (2b) aufweist, die auf eine stark dotierte Zone (2a) aufgewachsen ist, wobei die Dotierung des Bodens (16) der Gräben mit der stark dotierten Zone in Berührung ist.

3. Integrierte Schaltung nach Anspruch 1 oder 2, dadurch gekennzeichnet, daß das Leitermaterial (20) aus dotiertem polykristallinen Silicium oder aus einem hitzebeständigen Metallsilicid besteht.

4. Integrierte Schaltung nach einem der Ansprüche 1 bis 3, dadurch gekennzeichnet, daß ein lokales Feldoxid (22) oberhalb jedes Isolationsgrabens (10) vorgesehen ist.

5. Verfahren zur Herstellung von elektrischen Isolationszonen, die dazu dienen, die N-Kanal-MOS-Transistoren von den P-Kanal-MOS-Transistoren einer integrierten CMOS-Schaltung elektrisch zu isolieren, dadurch gekennzeichnet, daß es die folgenden Schritte umfaßt :

a) Ausbildung mehrerer Gräben (10) in einem Siliciumsubstrat (2) eines vorgegebenen Leitfähigkeitstyps,

b) thermische Oxidation des Substrats unter Ausbildung eines-Oxidfilms (12) auf den Flanken (14) und dem Boden (16) der Gräben,

c) Beseitigen des Teils (12a) des Oxidfilms (12), der sich auf dem Boden (16) der Gräben befindet,

d) Dotieren im Boden (16) der Gräben (10) mit demselben Leitfähigkeitstyp, wie das Substrat, und

e) Auffüllen der Gräben (10) mit einem Leitermaterial (20), das so eine Elektrode bildet, die mit dem der Masse der Schaltung entsprechenden Substrat (2) verbunden ist,

f) Ausbilden eines lokalen Feldoxids (22) über jedem Graben (10).

6. Herstellungsverfahren nach Anspruch 5, dadurch gekennzeichnet, daß man den Schritt c) durch anisotrope Ätzung des Oxidfilms (12) ausführt.

7. Herstellungsverfahren nach Anspruch 5 oder 6, dadurch gekennzeichnet, daß das Substrat (2) eine schwach dotierte Zone (2b), die über einer stark dotierten Zone (2a) liegt, enthält, wobei die schwach dotierte Zone (2b) durch Epitaxie auf der stark dotierten Zone (2a) erhalten wird, wobei die Dotierung des Bodens der Gräben mit der stark dotierten Zone in Kontakt ist.

8. Herstellungsverfahren nach einem der Ansprüche 5 bis 7, dadurch gekennzeichnet, daß der Schritt a) durch ein anisotropes Ätzverfahren ausgeführt wird.

9. Herstellungsverfahren nach einem der Ansprüche 5 bis 8, dadurch gekennzeichnet, daß das Füllmaterial (20) dotiertes polykristallines Silicium oder ein hitzebeständiges Metallsilicid ist.

10. Herstellungsverfahren nach Anspruch 9, dadurch gekennzeichnet, daß das polykristalline Silicium $n^+$- oder $p^+$-dotiert ist.

11. Herstellungsverfahren nach Anspruch 9, dadurch gekennzeichnet, daß das Silicid Wolframsilicid ist.

12. Herstellungsverfahren nach einem der Ansprüche 5 bis 11, dadurch gekennzeichnet, daß man den Schritt a) ausführt, nachdem man auf dem Substrat (2) eine Maske (6, 8) ausgebildet hat, die dazu dient, die Stellen von herzustellenden Isolationszonen zu definieren, und daß man diese Maske (6, 8) nach Ausbildung des lokalen Feldoxids (22) entfernt.

13. Herstellungsverfahren nach Anspruch 12, dadurch gekennzeichnet, daß die Maske aus Siliciumnitrid hergestellt wird.

FIG. 1

FIG. 2

FIG. 3

FIG. 4

FIG. 5

FIG. 6

FIG. 7

FIG. 8

FIG. 9

FIG. 10